# EUROPEAN PATENT APPLICATION

(11) **EP 4 350 787 A1**
(43) Date of publication of application: **10.04.2024**
(21) Application number: 22815733.5
(22) Date of filing: 14.04.2022
(51) Int. Cl.: H01L 33/64, G01N 21/01

(54) **LED LIGHT SOURCE DEVICE**

(30) Priority: 03.06.2021 JP 2021093749
(71) Applicant: HITACHI HIGH-TECH CORPORATION, Tokyo 105-6409 (JP)
(72) Inventor: SHIMIZU, Hayato, Tokyo 100-8280 (JP); HORIKAWA, Hiroshi, Tokyo 105-6409 (JP); TAKAHASHI, Takuya, Tokyo 105-6409 (JP); KAWAHARA, Tetsuji, Tokyo 105-6409 (JP)
(74) Representative: Mewburn Ellis LLP
(86) International application number: PCT/JP2022/017769
(87) International publication number: WO 2022/254977

(57) **Abstract**

An object of the present invention is to quickly stabilize a light amount of an LED light source device used in absorbance analysis and to suppress the fluctuation of the temperature due to disturbance. In an LED light source device according to the present invention, an LED substrate is disposed on a spacer, the substrate and the spacer are brought into contact with at least one of a device housing and a device lid, and a thermal conductivity of the substrate and a thermal conductivity of the spacer are higher than a thermal conductivity of the housing and a thermal conductivity of the lid (see FIG. 1).

## Description

### Technical Field

The present invention relates to an LED light source device.

### Background Art

A technique for measuring a substance contained in a sample by irradiating the sample with light is used in various analysis devices. For example, by measuring absorbance of a target substance, the substance can be quantified. As a light source, for example, a light emitting diode (LED) light source or the like can be used.

PTL 1 described below relates to a high performance liquid chromatography system. PTL1 describes a technique as : "Systems and methods are provided for a UV-VIS spectrophotometer, such as a UV-VIS detector unit included in a high-performance liquid chromatography system. In one example, a system for the UV-VIS detector unit may include a first light source, a signal detector, a flow path positioned intermediate the first light source and the signal detector, a second light source, and a reference detector. The first light source, the signal detector, and the flow path may be aligned along a first axis, and the second light source and the reference detector may be aligned along a second axis, different than the first axis."(see Abstract). The first and second light sources in this document are configured by, for example, LEDs (see 0050 of the document).

PTL 2 below describes an example of using an LED light source in a photopolymerizer that induces a photopolymerization reaction. This document aims to "provide an easily carried small-sized polymerizer that is capable of increasing intensity of light with which an object to be polymerized is irradiated, stably performing polymerization curing with high accuracy, and facilitates maintenance even in a case where the object contains a low-molecular-weight monofunctional polymerizable monomeric component that is volatilized by polymerization heat during polymerization curing, and where the component is attached and solidified as dirt in the device", and describes a technique of "reducing labor and cost of maintenance, by providing, as a light source, an LED package with a heat sink using a plurality of LEDs in a light source chamber, and covering an outer surface of a light transmissive window material for irradiating outside with light emitted from the light source with a protective film, and thus only the protective film can be replaced when dirt occurs" (see Abstract).

### Citation List

### Patent Literatures

PTL 1: Japanese Unexamined Patent Application Publication (Translation of PCT Application) No. 2020-526770
PTL 2: JP 2020-033392 A

### Summary of Invention

### Technical Problem

In order to improve analysis throughput of an analysis device using an LED light source, it is desirable to reduce, as much as possible, time required until a light amount of the LED light source is stabilized after power is turned on. Considering that the light amount of the LED light source is affected by temperature of a light source, it is necessary to quickly stabilize the temperature of the light source.

Even after the light amount of the LED light source is stabilized, the temperature of the light source may fluctuate due to the influence of various disturbances. Such fluctuation of the temperature also affects the light amount of the LED light source. Therefore, it is important to minimize the fluctuation of the temperature of the light source due to disturbance from the viewpoint of analysis accuracy.

In PTLs 1 and 2 described above, it is considered that there is a room for improvement in quick stabilization of the light amount when the LED light source is activated, and in suppression of fluctuation due to disturbance after the activation.

The present invention has been made in view of the above problems, and an object of the present invention is to quickly stabilize a light amount of an LED light source device used in absorbance analysis and to suppress the fluctuation of the temperature due to disturbance.

### Solution to Problem

In an LED light source device according to the present invention, an LED substrate is disposed on a spacer, the substrate and the spacer are brought into contact with at least one of a device housing or a device lid, and a thermal conductivity of the substrate and a thermal conductivity of the spacer are higher than a thermal conductivity of the housing and a thermal conductivity of the lid.

### Advantageous Effects of Invention

An LED light source device according to the present invention can quickly stabilize a light amount of an LED light source device used in absorbance analysis and to suppress fluctuation of the temperature due to disturbance. Other problems, configurations, advantages and the like of the present invention will become apparent with reference to the following embodiments.

### Brief Description of Drawing

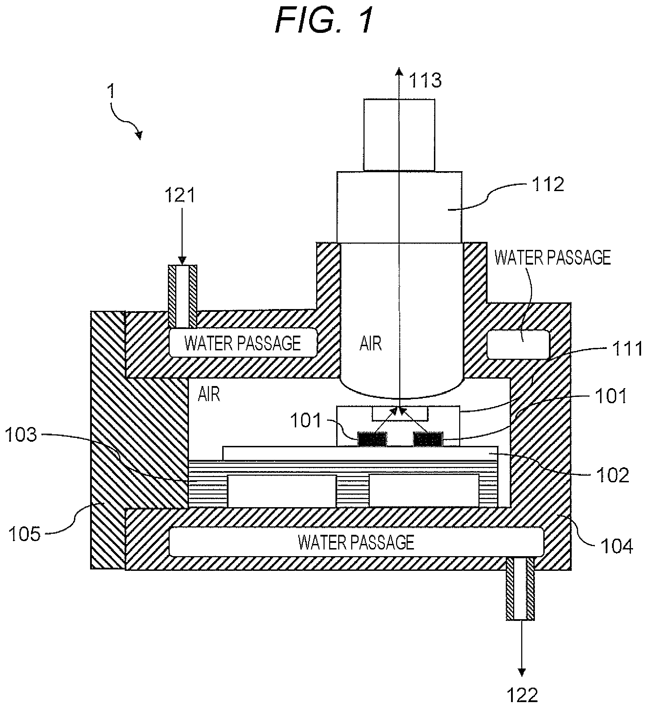

[FIG. 1] FIG. 1 is a cross-sectional view for illustration of a structure of an LED light source device 1 according to a first embodiment.

### Description of Embodiments

### <First embodiment>

FIG. 1 is a cross-sectional view for illustration of a structure of an LED light source device 1 according to a first embodiment of the present invention. The LED light source device 1 is used as a light source in an analysis device that quantifies a substance contained in a sample by measuring absorbance of the substance. For example, in an automatic analysis device that measures a measurement target substance contained in a blood sample by light irradiation, the LED light source device 1 can be used as a light source.

The LED light source device 1 has a structure in which a member such as a substrate 102 is housed within a housing 104 and is sealed by a lid 105. Light emitted by the LED light source device 1 is output through an optical path 113. Therefore, the optical path 113 has an opening portion at least on an optical axis (that is, at a position along an arrow next to a reference numeral 113 in FIG. 1).

An LED 101 is mounted on the substrate 102. A spacer 103 is a member that supports the substrate 102, and is in mechanical contact with the housing 104 as well as with the lid 105. By adjusting a position of the spacer 103, the optical axis of the light emitted from the LED 101 can be aligned with the opening portion of the optical path 113 and with the optical axis of an optical component 112. That is, the spacer 103 serves as a member that supports the substrate 102 and aligns the optical axis.

The light emitted from the LED 101 is multiplexed by a multiplexing device 111 and is emitted toward the optical path 113 via the optical component 112 (for example, a lens, a slit, or the like). This light is output through the opening portion of the optical path 113 via the optical component 112 (for example, a lens, a slit, or the like).

A water passage for circulating a constant temperature liquid (for example, water) for adjusting temperature of the LED light source device 1 is provided within the wall of the housing 104. The constant temperature liquid is supplied from an inlet 121 and is discharged from an outlet 122. The constant temperature liquid may be, for example, a constant temperature liquid used in a constant temperature reservoir provided for the automatic analysis device to maintain the temperature of the sample. In this case, the inlet 121 and the outlet 122 are connected to the constant temperature reservoir.

### <First embodiment: principle of device>

When the LED light source device 1 is powered on, the LED 101 emits light, and the temperature of the LED 101 (and its peripheral members) gradually rises with the lapse of time. An amount of the temperature rise (a rate of the temperature rise) with respect to the elapsed time gradually decreases, and the temperature stabilizes when the temperature reaches a certain level.

The light amount and a wavelength of the light emitted from the LED 101 have temperature characteristics, which vary depending on temperature. In order to ensure analysis accuracy in absorbance analysis, characteristics of emitted light need to be stable. Therefore, it can be said that it is desirable to quickly stabilize the characteristics of the emitted light after turning on the power of the LED light source device 1.

In order to quickly stabilize the characteristics of the emitted light, it is necessary to quickly increase the temperature of the LED 101 and its peripheral members up to a stable state. Therefore, in the first embodiment, heat capacity of the substrate 102 and heat capacity of the spacer 103 are reduced by reducing a volume of the substrate 102 and a volume of the spacer 103 as much as possible. Further, the substrate 102 and the spacer 103 are made of a material such as a metal having a high thermal conductivity (for example, aluminum). As a result, heat from the LED 101 efficiently propagates to the peripheral members such as the housing 104, so that the temperature of the LED 101 can be quickly raised to the stable state. As a result, the light amount and the wavelength of the LED 101 can be quickly stabilized.

In view of the above, a thermal conductivity of the substrate 102 and a thermal conductivity of the spacer 103 are desirably higher than both a thermal conductivity of the housing 104 and a thermal conductivity of the lid 105. For example, when at least one of the lid 105 or the housing 104 is made of phosphor bronze, it is desirable that both the thermal conductivity of the substrate 102 and the thermal conductivity of the spacer 103 be equal to or higher than a thermal conductivity of phosphor bronze. The thermal conductivity of the housing 104 and the thermal conductivity of the lid 105 can be, for example, 10 W/(m·k) or more and 50 W/(m·k) or less.

Even after an operation of the LED 101 is stabilized, for example, an air flow around the LED light source device 1 fluctuates to cause disturbance, which may fluctuate the temperature of the LED 101 and its peripheral members. As a result, there is a possibility that the light amount and the wavelength of the light emitted from the LED 101 fluctuate. Therefore, even after the operation of the LED 101 is stabilized, it can be said that it is desirable to reduce fluctuation of the temperature due to such disturbance.

Therefore, in the first embodiment, heat capacity of the housing 104 and heat capacity of the lid 105 are increased by increasing a volume of the housing 104 and a volume of the lid 105 as much as possible. As a result, the housing 104 and the lid 105 reduce the fluctuation of the temperature due to disturbance, and thus, it is possible to suppress the fluctuation of the temperature after the operation of the LED 101 is stabilized.

The fluctuation of the temperature due to disturbance can also be suppressed to some extent by the thermal conductivities of the housing 104 and of the lid 105, respectively. That is, when the thermal conductivity of these members is small, even if outside temperature fluctuates, the fluctuation can be suppressed from propagating within the device to some extent.

### <First embodiment: other members>

The water passage for circulating the constant temperature liquid serves as a temperature adjustment mechanism for adjusting the temperature of the LED light source device 1. The temperature of the constant temperature liquid is set to, for example, temperature higher than outside temperature of the LED light source device 1. In this case, if the temperature is desired to be lowered, an amount of heat to be propagated is reduced by reducing an amount of water, and the temperature is naturally lowered. Therefore, it is not necessary to separately provide an element or the like capable of performing a cooling operation, and there is an advantage that the temperature can be adjusted with a simple configuration.

The temperature adjustment mechanism can also be configured such that, instead of or in combination with the water passage, an element capable of both heating and cooling heats and cools the housing 104 and the lid 105. For example, it is conceivable to use a heater including a thermostat, a Peltier element, or the like in combination.

When a constant temperature liquid is used as the temperature adjustment mechanism, the constant temperature liquid may be shared with a constant temperature liquid circulation mechanism provided in the automatic analysis device to which the LED light source device 1 supplies light. The automatic analysis device may include a constant temperature reservoir for maintaining temperature of the sample constant and a constant temperature liquid is circulated around the constant temperature reservoir in order to maintain temperature of the constant temperature reservoir. An advantageous effect is provided in this case that, by supplying the constant temperature liquid to the LED light source device 1, the LED light source device 1 does not need to include a dedicated constant temperature liquid supply source.

When the constant temperature liquid is shared with the automatic analysis device, control of a flow rate of the constant temperature liquid and the like may be entrusted to the automatic analysis device. Alternatively, for example, the LED light source device 1 itself may have a flow rate control function by providing a flow rate regulating valve or the like within the LED light source device 1. A device such as a controller that gives a control instruction may be incorporated in the LED light source device 1 or may be configured as a device outside the LED light source device 1.

The optical path 113 has an opening that allows light emitted from the LED 101 to pass through. Through this opening, air is able to enter and exit between an internal space of the LED light source device 1 and the outside air. Such inflow and outflow of air becomes a factor that fluctuates the temperature of the internal space of the LED light source device 1, and thus it is desirable to suppress the inflow and outflow of air as much as possible. That is, it can be said that it is desirable to keep a size of the opening of the optical path 113 to a minimum necessary for emitting light.

In addition to the opening of the optical path 113, a hole may be provided in some cases that can ventilate between the internal space of the LED light source device 1 and the outside air. For example, a hole that allows a wiring for supplying power to the LED 101 to pass may be provided in a part of the lid 105. Even in this case, a size of an opening of the hole is desirably smaller than the size of the opening of the optical path 113. That is, it is desirable that ventilation capacity of the internal space of the LED light source device 1 provided by the size of the opening of the optical path 113 is maximum among other ventilation capacities. As a result, heat exchange between the internal space and the outside air is suppressed to the minimum, so that the fluctuation of the temperature of the LED 101 can be suppressed. Even in a case where a hole that allows ventilation is provided other than the opening of the optical path 113, if the hole can be sealed with an appropriate sealing material or the like, it is desirable to seal the hole.

Although the volume of the spacer 103 is also affected by the size of other members and the like, in order to reduce the heat capacity of the spacer 103 as much as possible, it is desirable that the volume of the spacer 103 be smaller than at least both the volume of the housing 104 and the volume of the lid 105. The same applies to the volume of the substrate 102.

### <First embodiment: summary>

In the LED light source device 1 according to the first embodiment, the thermal conductivity of the substrate 102 and the thermal conductivity of the spacer 103 are higher than both the thermal conductivity of the housing 104 and the thermal conductivity of the lid 105. As a result, the heat generated from the LED 101 quickly propagates, and thus, it is possible to quickly stabilize the light amount and the wavelength particularly when the LED 101 is powered on.

In the LED light source device 1 according to the first embodiment, by making the volume of the substrate 102 and the volume of the spacer 103 as small as possible (for example, smaller than both the volume of the housing 104 and the volume of the lid 105), the heat capacity of the substrate 102 and the heat capacity of the spacer 103 are reduced. This makes it possible to quickly stabilize the light amount and the wavelength particularly when the LED 101 is powered on.

In the LED light source device 1 according to the first embodiment, by making the volume of the housing 104 and the volume of the lid 105 as large as possible (for example, smaller than both the volume of the substrate 102 and the volume of the spacer 103), the heat capacity of the housing 104 and the heat capacity of the lid 105 are increased. This makes it possible to suppress the fluctuation of the temperature after the operation of the LED 101 is stabilized.

In the LED light source device 1 according to the first embodiment, the internal space of the housing 104 and the outside air can be ventilated through the opening of the optical path 113, and the size of the opening is smaller than sizes of other openings that enable ventilation of the internal space. As a result, the fluctuation of the temperature in the internal space can be suppressed to the minimum.

### <Second embodiment>

In the first embodiment, in order to determine whether or not the operation of the LED 101 is stabilized, for example, a criterion on whether or not dispersion of the light amount emitted by the LED 101 with respect to an average in immediately recent 10 minutes falls within 2% can be used. Similar criteria can also be used to determine whether or not the temperature of members such as the housing 104 and the lid 105 is stabilized. When the material, volume, and the like of each member of the LED light source device 1 are designed, the object of the present invention may be achieved under such criteria.

In the first embodiment, if an ON state is maintained for a relatively long time without frequently turning on and off the LED 101, the problem of quick stabilization of the wavelength of the light and the light amount when the LED 101 is powered on is alleviated. Even in this case, the effect of suppressing the influence of disturbance after the activation of the LED 101 in the first embodiment is useful. On the other hand, when the LED light source device 1 is used in a device that frequently turns on and off light, such as an automatic analysis device, the effect of the configuration of the first embodiment is remarkably exhibited.

In the first embodiment, when an amount of heat generated from the LED 101 is relatively small, the temperature adjustment mechanism can be omitted. On the other hand, the housing 104 and the lid 105 already provided with the temperature adjustment mechanism in the light source device using the light source having a relatively large amount of heat can also be used for the present invention. In this case, there is an advantage that most of the members excluding the light source itself, such as the substrate 102 and the LED 101, can be used.

In the first embodiment, it is desirable that the metal members are connected by means that minimizes a contact thermal resistance unless electrical insulation is required. For example, it is conceivable to use a thermal grease or the like.

### <Modifications of the present invention>

Note that the present invention is not limited to the above-described embodiments, and includes various modifications. For example, the above-described embodiments have been described in detail in order to describe the present invention in an easy-to-understand manner, and are not necessarily intended to limit to those having all of the described configurations. Further, a part of a configuration of one embodiment can be replaced with a configuration of another embodiment, and a configuration of one embodiment can be added to a configuration of another embodiment. Moreover, it is possible to add, delete, and replace another configuration for a part of the configuration of the embodiments.

In the above embodiments, even in a case where the spacer 103 is in mechanical contact with only one of the housing 104 or the lid 105, the spacer 103 can play the same role as that of the above embodiments via a member in contact.

### Reference Signs List

- 1: LED light source device
- 101: LED
- 102: substrate
- 103: spacer
- 104: housing
- 105: lid
- 113: optical path

## Claims

1. An LED light source device that emits light used to measure absorbance of a sample, the LED light source device comprising:
a light emitting element that emits the light;
a substrate on which the light emitting element is mounted;
a spacer that supports the substrate;
a housing that accommodates the light emitting element, the substrate, and the spacer; and
a lid that seals the housing,
wherein the light emitting element includes an LED,
wherein the spacer is disposed so as to be in contact with at least one of the housing or the lid, and
wherein a thermal conductivity of the substrate and a thermal conductivity of the spacer are higher than both of a thermal conductivity of the housing and a thermal conductivity of the lid.

2. The LED light source device according to claim 1, wherein the thermal conductivity of the housing and the thermal conductivity of the lid are both 10 W/(m·k) or more and 50 W/(m·k) or less.

3. The LED light source device according to claim 1, wherein the thermal conductivity of the substrate and the thermal conductivity of the spacer are both equal to or higher than a thermal conductivity of phosphor bronze.

4. The LED light source device according to claim 1, wherein the housing includes a temperature adjustment mechanism capable of adjusting temperature within the housing to be higher than outside temperature.

5. The LED light source device according to claim 4, wherein the temperature adjustment mechanism includes at least one of:
a mechanism that circulates a constant temperature liquid within the housing, or
a heater that heats the housing.

6. The LED light source device according to claim 4,
wherein the temperature adjustment mechanism includes a mechanism that circulates a constant temperature liquid within the housing, and
wherein the temperature adjustment mechanism is configured such that a decrease of a flow rate of the constant temperature liquid lowers the temperature within the housing.

7. The LED light source device according to claim 4, wherein the temperature adjustment mechanism adjusts the temperature within the housing using a constant temperature liquid used to maintain temperature of a constant temperature reservoir included in an automatic analysis device to which the LED light source device supplies the light.

8. The LED light source device according to claim 1, further comprising an optical path that allows the light emitted from the light emitting element to pass through,
wherein the optical path has an opening through which the light passes, and
wherein an internal space of the housing and outside air of the LED light source device are allowed to be ventilated through the opening.

9. The LED light source device according to claim 8,
wherein the lid has a hole that allows a wiring for supplying power to the light emitting element to pass through, and
wherein a size of an opening of the hole is smaller than a size of the opening of the optical path.

10. The LED light source device according to claim 1, wherein a volume of the spacer is smaller than both of a volume of the housing and a volume of the lid.
